Europäisches Patentamt

European Patent Office

Office européen des brevets

(19)

(11) **EP 0 888 557 B1**

(12) **EUROPÄISCHE PATENTSCHRIFT**

(45) Veröffentlichungstag und Bekanntmachung des Hinweises auf die Patenterteilung:
**04.06.2003 Patentblatt 2003/23**

(51) Int Cl.⁷: **G01R 33/12**

(21) Anmeldenummer: **97908238.5**

(86) Internationale Anmeldenummer:
**PCT/EP97/01301**

(22) Anmeldetag: **14.03.1997**

(87) Internationale Veröffentlichungsnummer:
**WO 97/037238 (09.10.1997 Gazette 1997/43)**

(54) **VERFAHREN ZUR BESTIMMUNG DES KRITISCHEN STROMES I c VON SUPRALEITERN UND MESSEINRICHTUNG ZUR DURCHFÜHRUNG DES VERFAHRENS**

PROCESS FOR DETERMINING THE CRITICAL CURRENT I c OF SUPERCONDUCTORS AND MEASURING INSTRUMENT THEREFOR

PROCEDE POUR DETERMINER LE COURANT CRITIQUE I c DES SUPRACONDUCTEURS ET SYSTEME DE MESURE POUR METTRE EN OEUVRE LEDIT PROCEDE

(84) Benannte Vertragsstaaten:
CH LI

(30) Priorität: **29.03.1996 DE 19612613**

(43) Veröffentlichungstag der Anmeldung:
**07.01.1999 Patentblatt 1999/01**

(73) Patentinhaber: **Forschungszentrum Karlsruhe GmbH**
**76133 Karlsruhe (DE)**

(72) Erfinder: **ULLMANN, Bernd**
**D-76133 Karlsruhe (DE)**

(56) Entgegenhaltungen:
US-A- 3 976 934          US-A- 4 132 949
US-A- 5 218 296

• **CRYOGENICS, Bd. 30, Nr. 5, 1.Mai 1990, Seiten 439-444, XP000117507 COLCLOUGH M S ET AL: "PULSED CRITICAL CURRENT MEASUREMENTS ON YBCO WIRES AND SCREEN-PRINTED FILMS"**

**Beschreibung**

Die Erfindung betrifft ein Verfahren und eine Meßeinrichtung zur Bestimmung des kritischen Stromes $I_c$ in Supraleitern über deren Leiterlänge, bekannt unter dem Begriff: magnetfeldbedingte, ortsaufgelöste Bestimmung der kritischen Stromdichte, kurz MOBS. Insbesondere dient das Verfahren zur Vermessung von supraleitenden Halbzeugen, Mehrkernsupraleitern, supraleitenden Kabeln oder einem Supraleiterkomposit mit z.B. helikal aufgebrachten oder kabeltechnisch sinnvoll gewickelten Supraleiterfilamenten auf einem Kunststoff-Rohr oder Kunststoff-Zylinder.

Der kritische Strom $I_c$ eines Supraleiters schwankt entlang des Leiters überwiegend auf Grund des anisotropen Aufbaus des Supraleiters oder der Supraleiterfilamente. Für den gesamten Leiter ist hinsichtlich der Stromtragfähigkeit - analog dem schwächsten Glied einer Kette - die geringste maßgebend. Daher ist die Ermittlung des kritischen Stromes $I_c$ bzw. seiner Schwankung über der Leiterlänge für die qualitative Beurteilung des Leiters wesentlich, bzw. können nach einer solchen Messung Leiterbereiche, die nur einen kritischen Strom $I_c$ unterhalb einer vorgesehenen Schranke führen können, herausgetrennt werden.

M. Polak et al. beschreibt in Cryogenics, 34, 805(1994), wie über den Halleffekt die Magnetisierung an Supraleitern gemessen wird. Hierbei sind gewisse Schwierigkeiten zu überwinden. Die einzelnen supraleitenden Filamente eines technisch relevanten Mehrkernleiters müssen während der Messung elektrisch gekoppelt sein. Die Kopplung ist u. a. von der Variation der Abstände der Einzelleiter und deren Querschnittsfläche abhängig. Daraus wird eine starke Variation der Magnetisierung über der Leiterlänge erwartet, die nicht mit dem Strom korrelieren muß.

Stand der Technik ist weiterhin, dass durch Anbringen vieler Spannungskontakte entlang eines nicht isolierten Supraleiters der lokale kritische Strom $I_c$ ermittelt wird. Das ist eine klassische Methode, die für den Laborbetrieb tolerabel, für die industrielle Qualitätskontrolle aber keineswegs praktikabel ist.

Eine weitere Methode wird von W. Zhu et al. in den Proc. to MRS 95, p 236. Boston, USA vorgeschlagen. Zhu ermittelt über Schleifkontakte den ortsaufgelösten kritischen Strom $I_c$. Hierzu muß wie bei der klassischen Methode der zu untersuchende Supraleiter elektrisch zugänglich sein, d. h. isolierte Supraleiter können mit einer elektrisch kontaktierenden Apparatur so nicht vermessen werden. Darüber hinaus besteht bei Schleifkontakten die Gefahr, dass sie beim Darüberschleifen den Supraleiter beschädigen.

In der US 3,976,934, von der ausgehend der jeweilige Oberbegriff der vorliegenden Ansprüche 1 und 3 gebildet ist, wird ein Verfahren und eine Apparatur für den kontinuierlichen, kontaktlosen Test eines langen, isolierten oder blanken Leiters beschrieben, der wenigstens teilweise aus supraleitendem Material besteht.

Der Leiter wird in dem Apparat im supraleitenden Zustand durch ein externes Magnetfeld bewegt, das Abschirmströme im supraleitenden Material induziert. Das von diesen Abschirmströmen hervorgerufenen Magnetfeld wird gemessen. Die Meßeinrichtung zur Durchführung des Verfahrens besteht aus einer Unterlage, über die der zur Vermessung vorgesehene Leiter ohne Seitenbewegung gezogen wird. Ein Magnet ist so verankert, dass die Achse des Magnetfeldes den Supraleiter unter einem vorgegebenen Winkel durchdringt.

Der Erfindung liegt die Aufgabe zugrunde, ein industriell einsetzbares Verfahren zur Ermittlung der Variation des kritischen Stromes $I_c$ über die Leiterlänge bei isolierten oder nicht isolierten Supraleitern anzugeben. Dazu soll eine Meßeinrichtung bereitgestellt werden, mit Hilfe derer der kritische Strom $I_c$ vollständig ermittelt werden kann und mit der auch bei Mehrkernsupraleitern zuverlässige Meßdaten gewonnen werden können.

Die Aufgabe wird mit dem Verfahren gemäß Anspruch 1 bzw. einer Meßeinrichtung mit den Merkmalen des Anspruchs 3 gelöst.

Mit dem Verfahren kann der Strom $I_c$ an nicht isolierten und isolierten Supraleitern und insbesondere an Mehrkernsupraleitern einfach und zuverlässig bestimmt werden. Der Spannungsabgriff kann an beliebiger Stelle des zu prüfenden Supraleiters oder auch nur an den beiden Supraleiterenden erfolgen, solange das durchdringende Magnetfeld zwischen den Spannungsabgriffen liegt. Beim isolierten Supraleiter wird die Spannung zweckmäßigerweise an den blank liegenden Stirnseiten des Supraleiters abgegriffen. Der Strom kann irgendwo im $I_c$-Stromkreis gemessen werden (Shunt-Messung z.B.). Beim nicht isolierten Supraleiter kann die Spannung durchaus in der Nähe, vor und hinter dem durchdringenden Magnetfeld abgegriffen werden. Mit Hilfe regelungstechnischer Zusatzeinrichtungen zur Spannungs- bzw. Stromkonstanthaltung werden der Strom bzw. die Spannung einfach erfaßt.

Der Unteranspruch 2 beschreibt einen Verfahrensschritt, der für deutliche Meßsignale sehr nützlich ist, nämlich dass die Magnetfeldachse und die Längsachse des Supraleiters ein Winkel von 90° miteinander bilden.

Der in Anspruch 3 gekennzeichnete, prinzipielle Aufbau der Meßeinrichtung zur Durchführung des Verfahrens muß gewährleisten, dass sich der Abstand des zu vermessenden Supraleiters beim Durchfahren des vom Magneten erzeugten Magnetfelds zum Magneten und sich der aus Leiterlängsachse und Magnetfeldachse gebildete Winkel während der Messung nicht ändern.

In Anspruch 4 ist eine zweckmäßige Magnetform, die C-Form, gekennzeichnet. Mit dem Magnetfeld im Luftspalt zwischen den Polen kann der kritische Strom $I_c$ im Supraleiter einfach erniedrigt werden. Ansprüche 5 und 6 kennzeichnen schließlich die Art des Magneten, den Permanent- oder Elektromagneten.

Beim nicht isolierten Einkernsupraleiter ist nach wie vor die Hall-Sonden Meßmethode zweckmäßig, insbesondere wenn der Einkernsupraleiter auf einem Substrat aufgebracht ist und keinen geraden Verlauf hat, sondern in zwei Dimensionen planar verläuft. Die Hall-Sonde kann nämlich dann dem Leiter leicht nachgeführt werden.

Supraleiter mit einer Matrixstruktur im Leiterquerschnitt, Mehrkernleiter oder helikal gewickelte Filamente oder sonst in Kabeltechnik gewickelte Filamente auf einem Träger und dergleichen, können mit der Hall-Sonden-Methode nicht vermessen werden. Hingegen ist mit MOBS ein Verfahren gegeben, mit dem nicht nur Rohleiter sondern auch Fertigprodukte zuverlässig zu vermessen sind. Selbst auf Zylinderprofile aufgebrachte Supraleiterfilamente, sog. Supraleiterkomposite, können durch Drehen des Leiters im durchdringenden Magnetfeld vermessen werden.

Die Vermessung des Supraleiters ohne Magnetfeldbeeinflussung, also B = 0, kann bei technischen Produkten, bei denen die Ic (B)-Abhängigkeit bekannt ist - und das ist sie im allgemeinen - entfallen. Allenfalls kann bei einem Stück Supraleiter einer Charge eine solche Messung mit Feld B = 0 zur Überprüfung und Stromnormierung vorgenommen werden.

Die Meßeinrichtung ist besonders einfach bei Hochtemperatursupraleitern einzusetzen, da der kryotechnische Aufwand mit zunehmender Sprungtemperatur zurückgeht und die $I_c$(B)-Charakteristik steil ist.

Die Ergebnisse, die mit dem Verfahren und der Meßeinrichtung gewonnen werden, werden im folgenden anhand der Zeichnung näher erläutert werden. Die Zeichnung besteht aus drei Figuren. Es zeigen:

Figur 1 den Verlauf des kritischen Stromes $I_c$ über der Länge des Supraleiters,
Figur 2 den schematischen Aufbau der Meßeinrichtung und
Figur 3 eine vergleichende Messung.

Der verwendete Supraleiter 1 ist 25 cm lang, 0.2 mm dick und 3,5 mm breit, er ist ein nichtisolierter Mehrkernsupraleiter. Der kritische Transportstrom $I_c$ beträgt 2,1 A. Die Meßtemperatur liegt bei 77 K, bei dieser Temperatur ist Stickstoff flüssig. Das Magnetfeld, das die kritische Stromtragfähigkeit schwächt, erzeugt ein Permanentmagnet der Maße 2 x 5 x 7 mm$^3$ oder 5 x 5 x 7 mm$^3$. Die Achse des durchdringenden Magnetfelds steht senkrecht auf der Leiterlängsachse des Supraleiters.

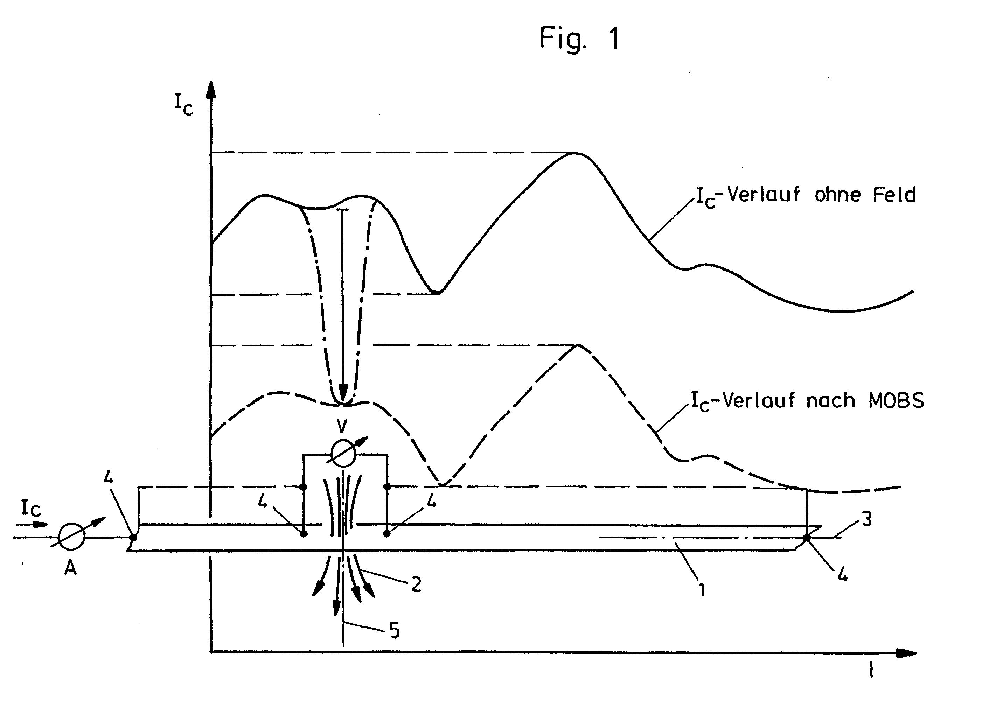

Zunächst wird zu Kontrollzwecken der Verlauf des kritischen Stromes $I_c$ über der Leiterlänge ohne durchdringendes Magnetfeld (B = 0) aufgenommen (Figur 1). Der Stromverlauf schwankt innerhalb eines Bandes, das vom Minimal- und Maximalwert des kritischen Stromes gebildet wird. Danach erfolgt die Messung erneut, jetzt mit der lokalen Durchdringung des Supraleiters durch das extern einwirkende Magnetfeld. Figur 1 zeigt diesen lokalen Einfluß und die dadurch bewirkte Minderung des kritischen Stromes $I_c$(B). Wesentlich ist, dass das Magnetfeld im Supraleiter so stark ist, dass der neue Verlauf des kritischen Stromes auf jeden Fall unterhalb des Bandes für den kritischen Strom $I_c$(0) liegt, dann ist sicher, dass das durchdringende Magnetfeld für die Minderung alleine verantwortlich ist. Die lokale $I_c$-Absenkung ist durch den strichpunktierten Verlauf angedeutet. Insgesamt ergibt sich der gestrichelte Verlauf für die Messung nach MOBS.

Zur Veranschaulichung beider Kurven für den kritischen Strom,
$I_c$ = f(l), mit l als Leiterlänge,
ist der Supraleiter im Schaubild mit angedeutet.

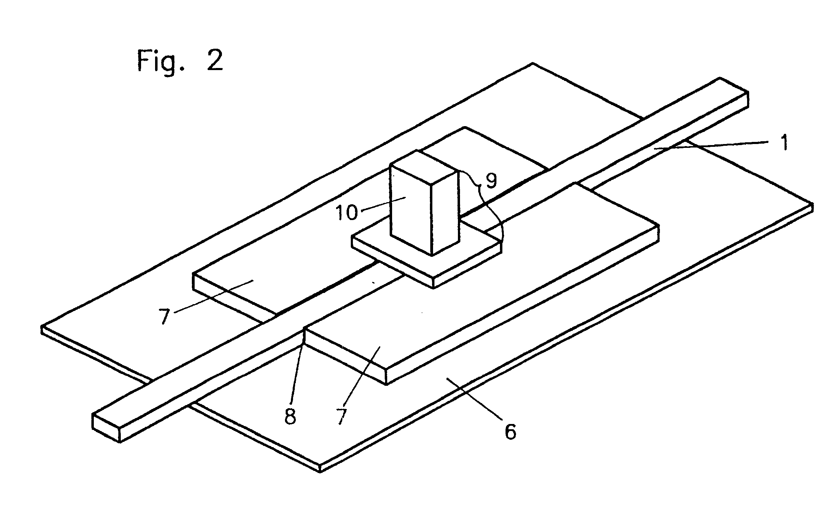

In Figur 2 ist die Meßeinrichtung schematisch dargestellt, mit der ein bandförmiger Supraleiter, der auf einer ebenen, zumindest oberflächenisolierten Platte aufliegt und durch zwei Anschläge bzw. Führungen, die eine Führungsrinne bilden, ohne seitliches Hin- und Herbewegen desselben während des Durchziehens vermessen wird. Der Magnet ist in einer vorgesehenen Position in einem Gestell über der Führungsrinne verankert, so dass während des Messens und Durchziehens des Supraleiters die Geometrie: Magnet - magnetfelddurchdrungenes Supraleiterstück, stets unverändert ist. Dadurch ist der B-Feld-behaftete, kritische Strom $I_c$ alleine auf den Einfluß des durchdringenden Magnetfelds zurückzuführen. Das Magnetfeld im durchdrungenen Supraleitervolumen muß nicht homogen sondern nur gleichartig sein. Je nach Polformung ist bei einem C-förmigen Magneten im Durchdringungsraum ein homogenes Durchdringungsfeld gut angenähert erreichbar.

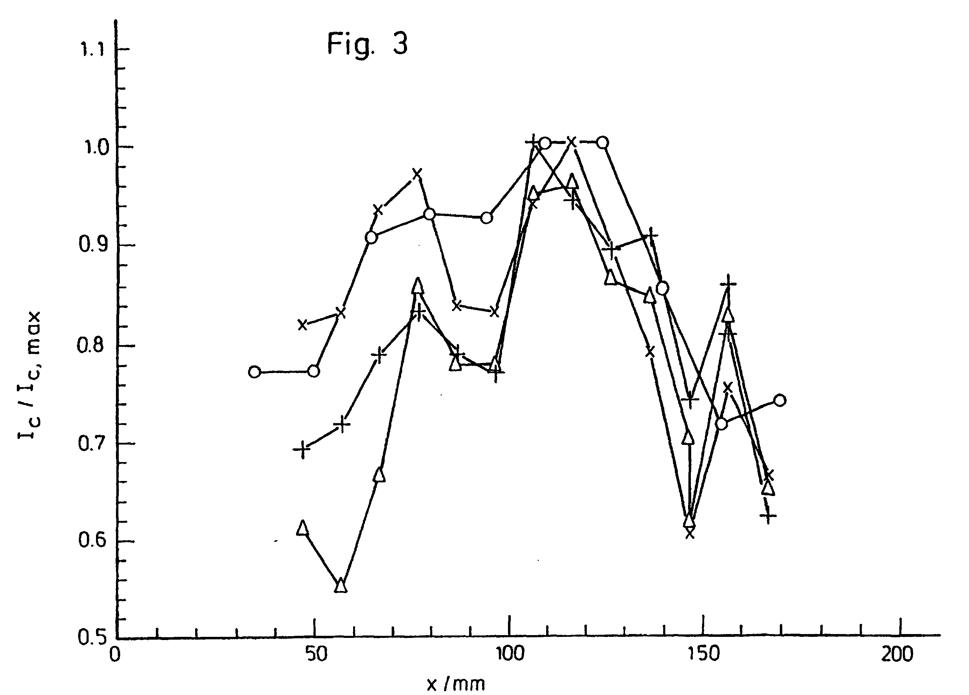

Die Leistungsfähigkeit des Verfahren zeigt sich im Vergleich mit der klassischen Methode: viele Potentialabgriffe am Supraleiter. Das ist in Figur 3 festgehalten:

Den Verlauf des normierten kritischen Stromes $i_c = I_c/I_{c\,max}$ über die Leiterlänge mit der klassischen Methode zeigt die Kurve mit Kreisen. Die Kurve mit Dreiecken ist eine nach dem MOBS-Verfahren bestimmte. Die beiden übrigen Kurven mit Plus- und X-Zeichen geben ebenfalls den normierten kritischen Strom $i_c$ nach dem MOBS-Verfahren wieder, allerdings mit einem kleineren Magneten bzw. einem schwächeren Magnetfeld.

Die Streuung des Stroms $I_c$ bzw. des normierten Transportstroms $i_c$ im durchgemessenen Leiter ist nach beiden Verfahren gleich. Mit dem MOBS-Verfahren erhält man sowohl dementsprechend reproduzierbare Ergebnisse lokal als auch bei einer erneuten Messung nach mehreren Wochen (Kurve mit Dreiecken). Letztere ist von Interesse, um bei dem vermessenen Hochtemperatur-Supraleiter (Bi 2223) eine Degradation durch Sauerstoff, mechanische Belastung, Abkühlung etc. erfassen zu können.

## Bezugszeichenliste:

1   Supraleiter
2   Magnetfeld
3   Leiterlängsachse
4   Kontaktstelle, Spannungsabgriff
5   Achse des Magnetfelds, Magnetfeldachse
6   Unterlage
7   Führung
8   Führungsrinne
9   Gestell
10  Magnet

## Patentansprüche

1.  Verfahren zur Bestimmung der Variation des kritischen Stromes $I_c$ von Supraleitern über deren Leiterlänge, bestehend aus den Schritten:

    ein elektrisch nach außen isolierter oder nicht isolierter Supraleiter (1), wie ein Einkernsupraleiter oder ein Mehrkernsupraleiter in Form eines Supraleiterkomposits oder Kabels, wird durch ein örtlich begrenztes Magnetfeld (2) gezogen und von demselben durchdrungen, wobei dessen Magnetfeldachse (5) eine unveränderte Lage zur dortigen Leiterlängsachse (3) des Supraleiters (1) einnimmt,

    **dadurch gekennzeichnet, dass**
    die Stärke des Feldes B des den Supraleiter durchdringenden Magnetfelds (2) derart eingestellt wird, dass der kritische Strom $I_c(B)$ an jedem Ort 1 entlang des Supraleiters (1) stets kleiner als der kritische Strom $I_c(0)$ ohne ein solch durchdringendes Magnetfeld (2) ist, also

    $$I_c(B)_{max} < I_c(0)_{min}$$

    ist,
    der Spannungsabfall zwischen zwei Kontaktstellen (4) gemessen wird, zwischen denen das Magnetfeld (2) durch den Supraleiter (1) dringt, und zwar an den beiden Supraleiterenden bei einem isolierten Supraleiter (1) bzw. an zwei beliebigen Kontaktstellen (4), zwischen denen das Magnetfeld (2) durch den Supraleiter (1) dringt, bei einem nicht isolierten Supraleiter,
    einerseits der Spannungsabfall in Abhängigkeit eines konstanten Stroms durch den isolierten Supraleiter kontinuierlich über die gesamte Länge bzw. diskret an vorgegebenen Stellen oder nach vorgegebenen Längenintervallen des nicht isolierten Supraleiters (1) gemessen wird oder

    andrerseits der Strom durch den Supraleiter (1) gemessen wird, indem der Spannungsabfall zwischen den beiden Kontaktstellen (4) auf einen konstanten Wert geregelt wird.

2.  Verfahren nach Anspruch 1,
    **dadurch gekennzeichnet, dass**
    die Achse (5) des den Supraleiter durchdringenden Magnetfelds (2) stets so eingestellt wird, dass sie senkrecht zur Längsachse (3) des Supraleiters (1 steht.

3.  Meßeinrichtung zur Durchführung des Verfahrens nach einem der Ansprüche 1 bis 2, bestehend aus:

    einer Unterlage (6), die zumindest auf ihrer Oberfläche elektrisch nicht leitend ist,
    einem Magneten (10), der in einem Gestell (9) so verankert ist, dass seine Magnetfeldachse den Supraleiter durchdringt,
    dem Gestell (9), das mit seiner Unterseite eine Führungsrinne (8) überbrückt, wobei sowohl der in dem Gestell verankerte Magnet (10) auf Abstand zum Supraleiter (1 als auch der Winkel zwischen der Magnetfeldachse und der Längsachse des in der Führungsrinne durchlaufenden Supraleiters (1) einstellbar sind, wobei die Achse (5) des Magnetfelds (2) den Supraleiter (1) in der Führungsrinne (8) unter einem vorgegebenen Winkel durchdringt und das den Supraleiter (1) durchdringende Magnetfeld (2) im durchdrungenen Supraleitervolumen eine vorgesehene Stärke aufweist,

    **dadurch gekennzeichnet, dass**
    zwei auf der Unterlage (6) verstell- und feststellbare Führungen. (7) aus dielektrischem Material vorhanden sind, mit denen die Führungsrinne (8) derart einstellbar ist, dass sich der durchzuziehende Supraleiter (1) in ihr nicht seitlich bewegen kann,
    wobei der Spannungsabgriff für ein Voltmeter am Supraleiter vor und hinter der lokalen Durchdringung des extern einwirkenden Magnetfelds und die Strommessung mit einem Amperemeter im Stromkreis des kritischen Stromes $I_c$ erfolgt.

4.  Meßeinrichtung nach Anspruch 3, **dadurch gekennzeichnet, dass** der Magnet (10) eine C-Form hat und die Führungsrinne (8) durch den Luftspalt des Magneten (10) verläuft, so dass eine wenig ausgeprägte Feldinhomogenität im felddurchdrungenen Supraleitervolumen besteht.

5.  Meßeinrichtung nach Anspruch 4, **dadurch gekennzeichnet, dass** der Magnet (10) ein Permanentmagnet ist.

6.  Meßeinrichtung nach Anspruch 4, **dadurch ge-**

**kennzeichnet, dass** der Magnet (10) ein konventioneller oder supraleitender Elektromagnet ist.

## Claims

1. Method for determining the variation of the critical current $I_c$ of superconductors over their conductor length, which consists of the following steps:

   An electrically insulated or not insulated superconductor (1), such as a single-core superconductor or a multi-core superconductor in the form of a superconductor composite or cable, is drawn through a locally limited magnetic field (2) and penetrated by the latter, with the magnetic field axis (5) having an unchanged position relative to the longitudinal axis (3) of the superconductor (1),

   **characterized by**
   the intensity B of the magnetic field (2) penetrating the superconductor being set such that the critical current $I_c(B)$ at any point I along the superconductor (1) is always smaller than the critical current $I_c(0)$ without such penetrating magnetic field (2), i.e.

   $$I_c(B)_{max} < I_c(0)_{min},$$

   the voltage drop being measured between two contact points (4), between which the magnetic field (2) penetrates the superconductor (1), that is at both superconductor ends of an insulated superconductor (1) or at any two contact points (4), between which the magnetic field (2) penetrates the superconductor (1) in case of a non-insulated superconductor,
   and the voltage drop being measured continuously over the entire length as a function of a constant current through the insulated superconductor or with the voltage drop being measured discretely at given points or given length intervals of the non-insulated superconductor (1) or alternatively
   the current through the superconductor (1) being measured by setting the voltage drop between both contact points (4) to a constant value.

2. Method according to Claim 1,
   **characterized by**
   the axis (5) of the magnetic field (2) penetrating the superconductor being always set such that it is located vertical to the longitudinal axis (3) of the superconductor (1).

3. Measurement system for the execution of the method according to one of Claims 1 or 2, which consists of:

   a base (6), the surface of which is electrically non-conductive at least,
   a magnet (10) that is anchored in a rack (9) such that its magnetic field axis penetrates the superconductor,
   a rack (9), the bottom side of which bridges a guiding channel (8) with both the distance between the magnet (10) anchored in the rack and the superconductor (1) as well as the angle between the magnetic field axis and the longitudinal axis of the superconductor (1) moved in the guiding channel being adjustable, while the axis (5) of the magnetic field (2) penetrating the superconductor (1) in the guiding channel (8) has a given angle and the magnetic field (2) penetrating the superconductor (1) has a specified intensity in the penetrated superconductor volume,

   **characterized by**
   two adjustable and fixable guiding units (7) of dielectric material being provided on the base, by means of which the guiding channel (8) can be adjusted such that the superconductor (1) to be drawn through cannot move to the sides, the voltage being measured by a voltmeter on the superconductor upstream and downstream of the point of local penetration of the external magnetic field, and current measurement taking place with an ammeter in the circuit of the critical current $I_c$.

4. Measurement system according to Claim 3, **characterized by** the magnet (10) having a C-shape and the guiding channel (8) being located in the air gap of the magnet (10), thus resulting in a slight field inhomogeneity in the superconductor volume penetrated by the field.

5. Measurement system according to Claim 4, **characterized by** the magnet (10) being a permanent magnet.

6. Measurement system according to Claim 4, **characterized by** the magnet (10) being a conventional or superconducting solenoid.

## Revendications

1. Procédé de détermination de la variation du courant critique $I_c$ de supraconducteurs par leur longueur conductrice, composé des opérations suivantes:

   un supraconducteur (1) isolé ou non isolé électriquement vers l'extérieur, comme p. ex. un supraconducteur mononucléaire ou un supraconducteur multinucléaire sous forme d'un composite supraconducteur ou d'un câble est tiré à travers un champ magnétique (2) limité localement et pénétré par celui-ci, l'axe du champ magnétique de celui-ci (5) occupant une position inchangée par rapport à l'endroit de l'axe longitudinal de conducteur (3) du supraconducteur (1),

**caractérisé en ce que**
l'intensité du champ B du champ magnétique (2) pénétrant le supraconducteur est réglée à un niveau tel que le courant critique $I_c(B)$ à chaque endroit I le long du supraconducteur (1) est toujours inférieur au courant critique $I_c(0)$ en l'absence d'un tel champ magnétique (2) pénétrant, donc

$$I_c(B)_{max} < I_c(0)_{min}$$

la baisse de tension est mesurée entre deux contacts (4) entre lesquels le champ magnétique (2) pénètre dans le supraconducteur (1), ou bien aux deux extrémités du supraconducteur dans le cas d'un supraconducteur isolé (1), ou à deux points de contact quelconques (4) entre lesquels le champ magnétique (2) pénètre dans le supraconducteur (1), dans le cas d'un supraconducteur non isolé, d'une part, la baisse de tension est mesurée en fonction d'un courant constant à travers le supraconducteur isolé, par des mesures discrètes à des endroits prédéfinis ou à des intervalles de longueur prédéfinis du supraconducteur (1 ) non isolé, ou d'autre part, le courant passant par le supraconducteur (1 ) est mesuré en réglant à une valeur constante la baisse de tension entre les deux contacts (4).

2. Procédé selon la revendication 1,
   **caractérisé en ce que**
   l'axe (5) du champ magnétique (2) pénétrant dans le supraconducteur est toujours ajusté en sorte qu'il soit perpendiculaire à l'axe longitudinal (3) du supraconducteur (1).

3. Equipement de mesure pour réaliser le procédé selon l'une des revendications 1 à 2, consistant en un support (6) non conducteur électriquement du moins à sa surface,
   un aimant (10) ancré dans un bâti (9) de telle manière que son axe de champ magnétique pénètre dans le supraconducteur,
   le bâti (9) dont la face inférieure forme un pont sur une gorge de guidage (8), l'écart du supraconducteur (1) par rapport à l'aimant (10) ancré dans la boîte ainsi que l'angle entre l'axe du champ magnétique et l'axe longitudinal du supraconducteur (1) passant par la gorge de guidage étant réglables, l'axe (5) du champ magnétique (2) pénétrant dans le supraconducteur (1) dans la gorge de guidage (8) sous un angle prédéfini et le champ magnétique (2) pénétrant dans le supraconducteur (1) présentant une intensité prédéfinie dans le volume du supraconducteur pénétré,
**caractérisé en ce que**
sur le support (6) se trouvent deux éléments de guidage (7) mobiles et verrouillables en matériau diélectrique permettant d'ajuster la gorge de guidage (8) de telle façon que le supraconducteur (1) à faire passer dedans ne peut pas se déplacer latéralement dans celle-ci,
la prise de tension pour un voltmètre s'effectuant sur le supraconducteur devant et derrière la pénétration locale du champ magnétique agissant extérieurement et
la mesure du courant s'effectuant à l'aide d'un ampèremètre dans le circuit du courant critique $I_c$.

4. Dispositif de mesure selon la revendication 3, **caractérisé en ce que** l'aimant (10) présente une forme en C et que la gorge de guidage (8) traverse l'entrefer de l'aimant (10), de sorte qu'il existe une inhomogénéité peu marquée du champ dans le volume supraconducteur pénétré par le champ.

5. Dispositif de mesure selon la revendication 4, **caractérisé en ce que** l'aimant (10) est un aimant permanent.

6. Dispositif de mesure selon la revendication 4, **caractérisé en ce que** l'aimant (10) est un électroaimant classique ou supraconducteur.

# Fig. 1

$I_C$

$I_C$-Verlauf ohne Feld

$I_C$-Verlauf nach MOBS

$I_C$

A

4

4

4

4

V

2

5

3

1

l

EP 0 888 557 B1

Fig. 2

EP 0 888 557 B1

Fig. 3

EP 0 888 557 B1